# EUROPÄISCHE PATENTSCHRIFT

(11) **EP 1 423 719 B1**
(45) Veröffentlichungstag und Bekanntmachung des Hinweises auf die Patenterteilung: **13.04.2005**
(21) Anmeldenummer: 02754395.8
(22) Anmeldetag: 19.07.2002
(51) Int. Cl.: G01R 31/28, G01R 31/02

(54) **VERFAHREN UND VORRICHTUNG ZUM ÜBERWACHEN EINER SENSOREINHEIT**
METHOD AND DEVICE FOR MONITORING A SENSOR UNIT
PROCEDE ET DISPOSITIF POUR CONTROLER UNE UNITE DE DETECTION

(30) Priorität: 29.08.2001 DE 10142169
(43) Veröffentlichungstag der Anmeldung: 02.06.2004
(73) Patentinhaber: ROBERT BOSCH GMBH, 70442 Stuttgart (DE)
(72) Erfinder: SCHMIDT, Wolfgang, 71665 Vaihingen (DE)
(86) Internationale Anmeldenummer: PCT/DE2002/002655
(87) Internationale Veröffentlichungsnummer: WO 2003/027684

(56) Entgegenhaltungen:
- DE-A- 3 506 114
- US-A- 5 294 890

## Beschreibung

Die Erfindung betrifft allgemein ein Verfahren zum Überwachen von Schaltungseinheiten, die zur Erfassung von Messsignalen eingesetzt sind, und betrifft insbesondere ein Verfahren zum Überwachen einer Sensoreinheit, bei dem ein analoges Prüfsignal ausgewertet wird.

Bei zahlreichen Messsystemen ist die Überwachung der den Messsystemen zugrundeliegenden Sensoreinheiten von entscheidender Bedeutung. Die Anwendungen reichen von einer einfachen, manuellen Überprüfung der Funktionsfähigkeit der Sensoreinheit mittels analoger Prüfsignale bis hin zu Messsystemen mit einer Selbstdiagnose bezüglich ihrer Sensoreinheiten.

Die DE 42 22 475 A1 beschreibt eine Anordnung zum Ausblenden von Störsignalen auf Signalleitungen, wobei eine erste Signalleitung ein digitales Originalsignal und eine zweite Signalleitung ein dazu invertiertes Signal überträgt und die beiden Signalleitungen an ihrem Ende an einem ersten und einem zweiten Eingang eines UND-Gatters anliegen, wobei das invertierte Signal über einen dem UND-Gattereingang vorgeschalteten Invertierer am Eingang des UND-Gatters anliegt, und am Ausgangs des UND-Gatters das störungsfreie Originalsignal abgreifbar ist.

Ein Nachteil herkömmlicher Verfahren zum Ausblenden von Störsignalen auf Signalleitungen besteht darin, dass eine Auswerteschaltung durch Bildung eines invertierten bzw. differenzierten Originalsignals aufwendig und kostenintensiv ist.

Die DE 41 18 718 beschreibt eine Prüfschaltung für einen Sensor, mit einer Offset-Spannungsquelle, einem "Pull-Down"-Widerstand und ersten und zweiten Prüftransistoren, um eine fehlerhafte Sensoreinheit bzw. einen Masseschluss oder einen Schluss gegen die Versorgungsspannung von Sensorsignalpfaden zu erkennen.

In nachteiliger Weise ist der Einsatz zweier Prüftransistoren in der Prüfschaltung für eine Sensoreinheit selbst störanfällig, aufwendig und kostenintensiv, so dass eine derartige Auswerteschaltung in rauen Erfassungsumgebungen nur schwer oder überhaupt nicht einsetzbar ist.

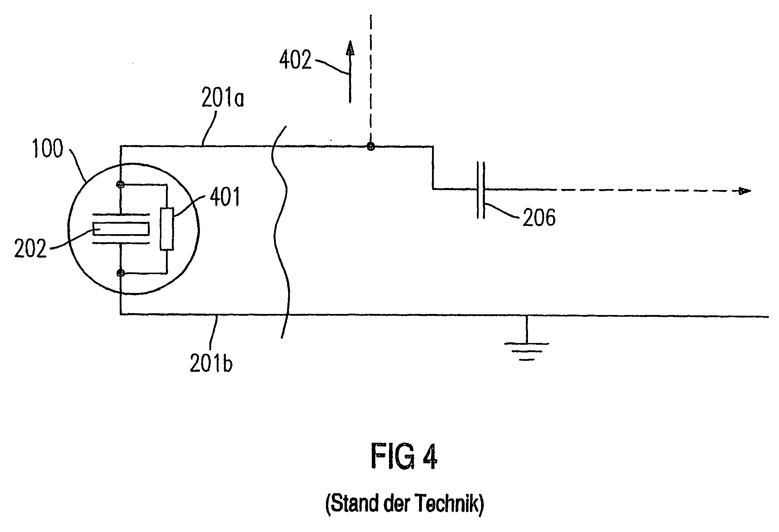

Figur 4 zeigt eine herkömmliche Überwachungsvorrichtung für eine Sensoreinheit 100, bei welcher ein hochohmiges Ableitwiderstandselement 401 parallel zu einem Sensorelement 202 der Sensoreinheit 100 geschaltet ist.

In herkömmlicher Weise dient das hochohmige Ableitwiderstandselement 401 dazu, bei einer Erwärmung des Sensors auftretenden Pyrospannungen, welche insbesondere bei einer Verwendung eines Piezoelementes als das Sensorelement 202 auftreten, abzuleiten. Das Sensorsignal wird in herkömmlicher Weise über eine Koppelkapazität 206 zu einer Weiterverarbeitungsschaltung abgeleitet.

Als ein Prüfsignal 402 kann lediglich eine Widerstandsmessung des hochohmigen Ableitwiderstandselementes 401 bereitgestellt werden. Da das hochohmige Ableitwiderstandselement 401 einen Widerstand in der Größenordnung von 5 MOhm aufweist, ist es schwierig, wenn nicht unmöglich, diesen Widerstandswert gegenüber Widerstandswerten zu unterscheiden, die beispielsweise durch eine Betauung des Sensors hervorgerufen werden. Insbesondere kann bei einer Überprüfung des hochohmigen Ableitwiderstandselementes 401 ein korrektes Betriebsverhalten vorgetäuscht werden, auch dann, wenn ein erster Sensorsignalpfad 201a und/oder ein zweiter Sensorsignalpfad 201b unterbrochen sind.

Weiterhin kann in nachteiliger Weise eine Alterung des Sensorelementes nicht zuverlässig bestimmt werden. Ein weiterer Nachteil der herkömmlichen Vorrichtung zur Sensorüberwachung besteht darin, dass bei horizontaler Kennlinie der Empfindlichkeit über der Frequenz niedrige Störfrequenzen außerhalb eines Nutzfrequenzbereichs in eine Auswerteeinheit gelangen können.

Es ist daher eine Aufgabe der vorliegenden Erfindung, ein Verfahren zum Überwachen einer Sensoreinheit bereitzustellen, bei dem ein analoges Prüfsignal durch eine Auslegung eines Ableitwiderstandselementes derart bereitgestellt wird, dass eine zuverlässige Erkennung von Fehlfunktionen des Sensorelementes und/oder von Fehlern wie beispielsweise Kurzschlüssen, Masseschlüssen und/oder Unterbrechungen von Sensorsignalpfaden erfasst werden.

Diese Aufgabe wird erfindungsgemäß durch das im Patentanspruch 1 angegebene Verfahren sowie durch eine Vorrichtung mit den Merkmalen des Patentanspruchs 20 gelöst.

Weitere Ausgestaltungen der Erfindung ergeben sich aus den Unteransprüchen.

Ein wesentlicher Gedanke der Erfindung besteht darin, dass ein parallel zu dem Sensorelement der zu überwachenden Sensoreinheit geschaltetes Ableitwiderstandselement zusammen mit einem in einer Auswerteeinheit angeordneten Spannungsteilerwiderstandselement einen Spannungsteiler bildet, welcher ein analoges Prüfsignal für eine Gleichspannungs-(DC-) Auswertung bereitstellt, wobei eine Auswertungsmöglichkeit eines Messsignals uneingeschränkt erhalten bleibt.

Es ist ein Vorteil, dass das erfindungsgemäße Verfahren zum Überwachen einer Sensoreinheit unabhängig vom Betriebspunkt der Sensoreinheit arbeitet.

Das erfindungsgemäße Verfahren zum Überwachen einer Sensoreinheit weist die in Anspruch 1 definierten Schritte auf.

In den Unteransprüchen finden sich vorteilhafte Weiterbildungen und Verbesserungen des jeweiligen Gegenstandes der Erfindung.

Gemäß einer bevorzugten Weiterbildung der vorliegenden Erfindung wird mittels eines Analog-Digital-Konverters eine Konvertierung des analogen Prüfsignals in ein digitales Prüfsignal bereitgestellt.

Gemäß einer weiteren bevorzugten Weiterbildung der vorliegenden Erfindung wird in einer Auswerteeinheit eine Gleichspannungsauswertung derart durchgeführt, dass ein einem Gleichspannungspegel entsprechender digitaler Wert des digitalen Prüfsignals ausgewertet wird.

Gemäß noch einer weiteren bevorzugten Weiterbildung der vorliegenden Erfindung wird in der Auswerteeinheit eine Unterbrechung eines ersten Sensorsignalpfads und/oder eine Unterbrechung eines zweiten Sensorsignalpfads und/oder eine elektrische Verbindung zwischen dem ersten Sensorsignalpfad und dem zweiten Sensorsignalpfad erfasst.

Gemäß noch einer weiteren bevorzugten Weiterbildung der vorliegenden Erfindung wird eine elektrische Verbindung zwischen dem ersten Sensorsignalpfad und/oder dem zweiten Sensorsignalpfad und einem Massepfad erfasst.

Gemäß noch einer weiteren bevorzugten Weiterbildung der vorliegenden Erfindung bewirkt ein in der Sensoreinheit parallel zu dem mindestens einen Sensorelement geschaltetes Ableitwiderstandselement einen Verlauf einer Sensorempfindlichkeit als Funktion einer Frequenz in der Form einer Hochpasssensorkennlinie.

Gemäß noch einer weiteren bevorzugten Weiterbildung der vorliegenden Erfindung bewirkt die durch die Beschaltung mit dem Ableitwiderstandselement gebildete Hochpasssensorkennlinie, dass nur ein vorgebbarer Nutzfrequenzbereich über die ersten und zweiten Sensorsignalpfade übertragen wird.

In vorteilhafter Weise liegt ein Nutzfrequenzbereich vorgebbar in einem Betriebsbereich der Sensoreinheit bzw. des zu messenden Messobjekts, beispielsweise in'dem Bereich von 1 kHz bis 30 kHz.

Gemäß noch einer weiteren bevorzugten Weiterbildung der vorliegenden Erfindung bildet ein Spannungsteilerwiderstandselement zusammen mit dem in Reihe geschalteten Ableitwiderstandselement einen Spannungsteiler derart, dass an einem Spannungsteilerausgangsanschluss das analoge Prüfsignal erhältlich ist.

Gemäß noch einer weiteren bevorzugten Weiterbildung der vorliegenden Erfindung wird ein Messsignal, welches den von dem Sensor zu erfassenden Messeffekt wiederspiegelt, von der Sensoreinheit über eine Koppelkapazität ausgegeben.

Gemäß noch einer weiteren bevorzugten Weiterbildung der vorliegenden Erfindung ist ein Massepfad der Sensoreinheit vorgebbar mit einer Systemmasse und/oder dem ersten Sensorsignalpfad und/oder dem zweiten Sensorsignalpfad verbunden.

Gemäß noch einer weiteren bevorzugten Weiterbildung der vorliegenden Erfindung wird als eine Versorgungsspannung eine positive oder eine negative Spannung bezogen auf ein Massepotential einer Masse bereitgestellt.

Gemäß noch einer weiteren bevorzugten Weiterbildung der vorliegenden Erfindung wird das analoge Prüfsignal asymmetrisch ausgewertet, wobei die Sensoreinheit bezogen auf den Massepfad geschaltet wird.

Gemäß noch einer weiteren bevorzugten Weiterbildung der vorliegenden Erfindung bewirkt das in Reihe zu dem Ableitwiderstandselement geschaltete Spannungsteilerwiderstandselement eine Dämpfung bzw. eine Absenkung der Empfindlichkeit bei niedrigen, nicht im Nutzfrequenzbereich liegenden Frequenzen.

Gemäß noch einer weiteren bevorzugten Weiterbildung der vorliegenden Erfindung wird das Prüfsignal symmetrisch ausgewertet, wobei ein Spannungsteiler mit zwei Widerständen bereitgestellt wird.

Die erfindungsgemäße Vorrichtung zur Überwachung einer Sensoreinheit durch Auswertung eines analogen Prüfsignals gemäß dem Verfahren nach Anspruch 1 weist weiterhin auf:
a) ein in der Sensoreinheit parallel zu einem Sensorelement geschaltetes Ableitwiderstandselement;
b) erste und zweite Sensorsignalpfade;
c) ein Spannungsteilerwiderstandselement, das zusammen mit dem Ableitwiderstandselement einen Spannungsteiler ausbildet; und
d) einen Spannungsteilerausgangsanschluss zur Ausgabe des analogen Prüfsignals.

Ausführungsbeispiele der Erfindung sind in den Zeichnungen dargestellt und in der nachfolgenden Beschreibung näher erläutert.

In den Zeichnungen zeigen:
- Figur 1: ein Blockbild einer Vorrichtung zur Überwachung einer Sensoreinheit gemäß einem bevorzugten Ausführungsbeispiel der vorliegenden Erfindung;
- Figur 2: eine Schaltungsanordnung zur Überwachung einer Sensoreinheit gemäß einem bevorzugten Ausführungsbeispiel der vorliegenden Erfindung in größerem Detail;
- Figur 3: einen Verlauf einer Sensorempfindlichkeit als Funktion der Frequenz sowohl nach einem herkömmlichen Verfahren als auch nach dem erfindungsgemäßen Verfahren zum Überwachen einer Sensoreinheit;
- Figur 4: eine herkömmliche Schaltungsanordnung zur Überwachung einer Sensoreinheit; und
- Figur 5: eine schematische Darstellung von zu überwachenden Fehlerfällen bzw. Fehlfunktionen und/oder Fehlern in Sensorsignalpfaden, die mit dem erfindungsgemäßen Verfahren zum Überwachen einer Sensoreinheit zu erfassen sind.

In den Figuren bezeichnen gleiche Bezugszeichen gleiche oder funktionsgleiche Komponenten oder Schritte.

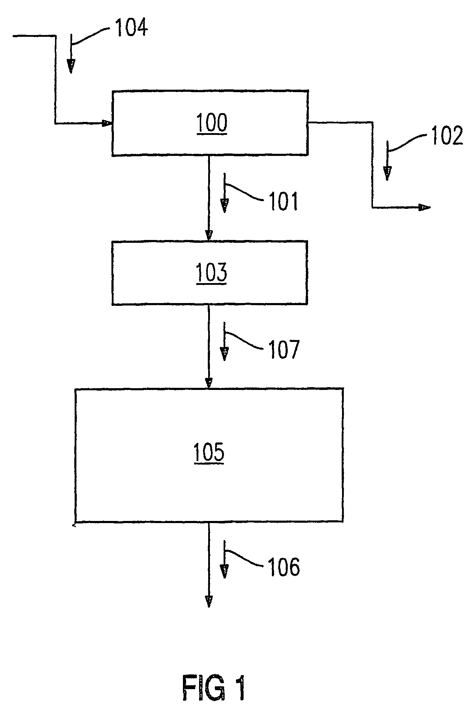

In dem in Figur 1 gezeigten schematischen Blockbild gemäß einem bevorzugten Ausführungsbeispiel der vorliegenden Erfindung wird eine Messgröße 104 von einer Sensoreinheit 100 erfasst. Ein von der Sensoreinheit ausgegebenes Messsignal 102 dient als eine Messgröße, um beispielsweise einen Prozess zu steuern oder zu regeln.

Weiterhin wird von der Sensoreinheit 100 ein analoges Prüfsignal 101 ausgegeben, welches einem Analog-Digital-Konverter 103 zugeführt wird. Nach einer Konvertierung des analogen Prüfsignals 101 in dem Analog-Digital-Konverter 103 wird ein digitales Prüfsignal 107 erhalten, welches einer Auswerteeinheit 105 zugeführt wird.

Eine auf einer digitalen Basis durchgeführte Auswertung des digitalen Prüfsignals 107 in der Auswerteeinheit 105 liefert ein Fehlerbestimmungssignal 106, welches weiteren Schaltungsblöcken zur Weiterverarbeitung bereitgestellt wird.

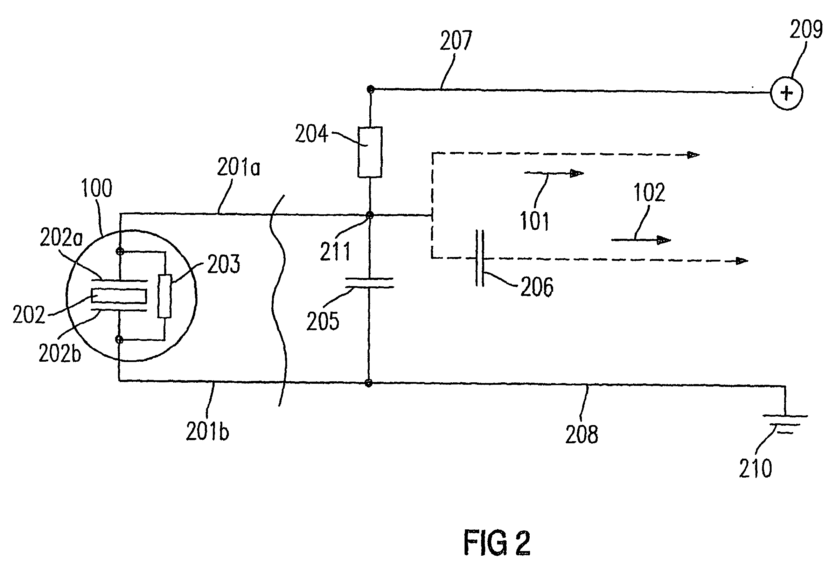

Figur 2 zeigt eine Schaltungsanordnung gemäß einem bevorzugten Ausführungsbeispiel der vorliegenden Erfindung in größerem Detail. Vorzugsweise, aber nicht ausschließlich, wird die Sensoreinheit 100 als Klopfsensor eines Motors in einem Fahrzeug verwendet, wobei das in der Sensoreinheit 100 enthaltene Sensorelement 202 als ein Piezoelement ausgebildet ist, um eine von einer Krafteinwirkung auf das Sensorelement abhängige Ladung an einer ersten Sensorelementkontaktierung 202a und einer zweiten Sensorelementkontaktierung 202b bereitzustellen.

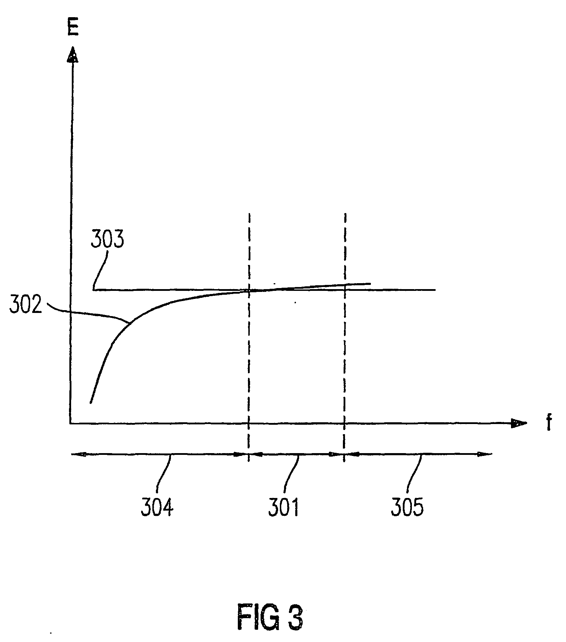

Hierbei wirkt die Sensoreinheit 100 im Wesentlichen als ein akustischer Aufnehmer, welcher eine einwandfreie Funktionsfähigkeit des Motors des Fahrzeuges überwacht. Ein interessierender Frequenzbereich, d.h. ein Nutzfrequenzbereich 301 (detailliert beschrieben unter Bezugnahme auf Figur 3) liegt hierbei typischerweise zwischen 1 kHz und 30 kHz.

Eine Amplitude einer typischen Frequenz, beispielsweise 10 kHz, wird aufgenommen und als das Messsignal 102 von der Sensoreinheit bzw. von einer angeschlossenen Auswerteeinheit ausgegeben. Durch ein Sensormaterial eines Piezoelementes wird weiterhin ein pyroelektrischer Effekt hervorgerufen, d.h. eine Erwärmung des Sensorelementes führt zü.einer Ladungserhöhung an den ersten und zweiten Sensorelementkontaktierungen 202a bzw. 202b. Um diese unerwünschte, sich langsam aufbauende Ladung zu beseitigen, ist ein Ableitwiderstandselement 203 parallel zu dem Sensorelement 202 geschaltet, so dass Ladungen, welche nicht durch ein Messsignal (akustisches Signal) im Nutzfrequenzbereich hervorgerufen werden, über das Ableitwiderstandselement 203 abfließen.

In herkömmlichen Sensoreinheiten ist dieses Ableitwiderstandselement als ein hochohmiges Ableitwiderstandselement 401 ausgebildet, wie obenstehend unter Bezugnahme auf Figur 4 beschrieben. Bevorzüglich wird das Ableitwiderstandselement 203 auf einem niedrigen Wert, typischerweise 50 kOhm gehalten, was die im Folgenden zu beschreibenden schaltungstechnischen Vorteile mit sich bringt.

Die erste Sensorelementkontaktierung 202a ist mit einem ersten Sensorsignalpfad 201a verbunden, während die zweite Sensorelementkontaktierung 202b mit einem zweiten Sensorsignalpfad 201b verbunden ist. Die beiden Sensorsignalpfade 201a und 201b sind unter anderem durch ein analoges Prüfsignal 101 zu überwachen.

Zwischen einem Spannungsteilerausgangsanschluss 211, der als Ausgangsanschluss für eine Bereitstellung des analogen Prüfsignals 101 und als Ausgangsanschluss für eine Bereitstellung des Messsignals 102 dient, und einem Versorgungsspannungspfad 207, der mit einer Versorgungsspannung 209 beaufschlagt ist, ist ein Spannungsteilerwiderstandselement 204 geschaltet. Die Versorgungsspannung 209 kann als eine positive oder als eine negative Versorgungsspannung bereitgestellt werden.

Wie in Figur 2 veranschaulicht, bildet das Spannungsteilerwiderstandselement 204 zusammen mit dem Ableitwiderstandselement 203 einen Spannungsteiler, welcher die Versorgungsspannung 209 entsprechend den Widerstandsverhältnissen aufteilt. Vorzugsweise, aber nicht darauf beschränkt, erfolgt eine 1:1-Teilung der Versorgungsspannung 209 derart, dass in einem vorgesehenen, einwandfreien Betriebszustand das Ableitwiderstandselement 203 zusammen mit den ersten und zweiten Sensorsignalpfaden 201a, 201b und das Spannungsteilerwiderstandselement 204 gleiche Widerstandswerte aufweisen.

Tritt eine Fehlfunktion, beispielsweise eine Leitungsunterbrechung in dem ersten Sensorsignalpfad 201a und/oder dem zweiten Sensorsignalpfad 201b auf, erhöht sich die an dem Spannungsteilerausgangsanschluss 211 als analoges Prüfsignal 101 abgreifbare Gleichspannung auf einen Wert der Versorgungsspannung 209.

In ähnlicher Weise wirkt sich ein Masseschluss des ersten Sensorsignalpfads 201a und/oder des zweiten Sensorsignalpfads 201b bzw. ein Kurzschluss zwischen dem ersten Sensorsignalpfad 201a und dem zweiten Sensorsignalpfad 201b aus. Hierbei wird das Prüfsignal 101 auf ein Massepotential eines Massepfads 208 abgesenkt.

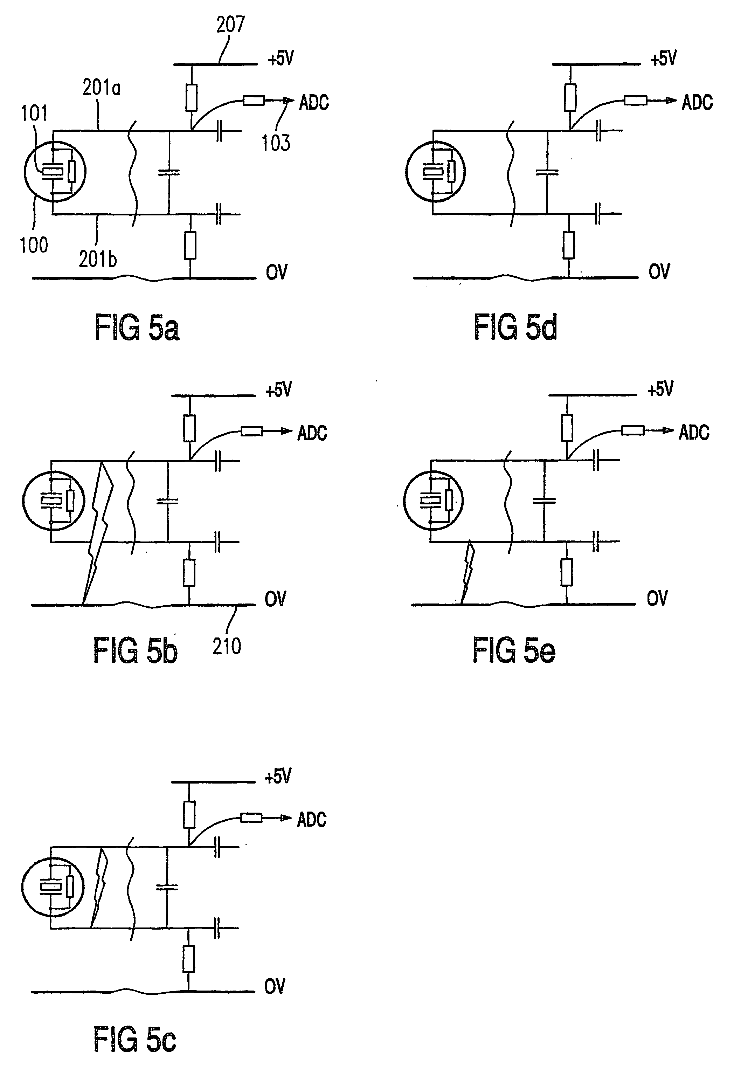

Weiterhin variiert die Spannung des analogen Prüfsignals 101 zwischen einem Massepotential des Massepfads 208 und einer Versorgungsspannung 209 eines Versorgungsspannungspfads 207. Zwischen dem Spannungsteilerausgangsanschluss 211 und dem Massepfad 208 liegt eine Entstörkapazität 205, die dazu dient, hochfrequente Störanteile, welche von der Sensoreinheit 100 herrühren, bzw. über den ersten und zweiten Sensorsignalpfad 201a, 201b übertragen werden, zu eliminieren oder zumindest zu verringern. Eine Koppelkapazität 206 dient dazu, das Messsignal 102 gleichstromfrei auszukoppeln. Auf diese Weise können die unter Bezugnahme auf Figur 5 beschriebenen Störfälle bzw. Fehlerfälle analysiert werden und als Prüfsignal 101 ausgegeben werden.

Weiterhin ist ein Analog-Digital-Konverter 103 bereitgestellt, um eine Konvertierung des analogen Prüfsignals 101 in ein digitales Prüfsignal 107 zu bewirken, so dass in der Auswerteeinheit 105 eine digitale Auswertung des digitalen Prüfsignals erfolgen kann, um ein Fehlerbestimmungssignal 106 zu erzeugen. Die ersten und zweiten Sensorsignalpfade 201a, 201b können, beispielsweise parallel verlaufend, eine Länge von mehreren Metern aufweisen, ohne dass eine Verfälschung des analogen Prüfsignals 101 auftritt, da das Ableitwiderstandselement 203 und das Spannungsteilerwiderstandselement 204 einen Spannungsteiler bilden.

Weiterhin ist das Spannungsteilerwiderstandselement 204 durch eine Stromquelle ersetzbar, die einen Strom über die ersten und zweiten Sensorsignalpfade 201a, 201b und das Ableitwiderstandselement 203 einprägt.

Die Auswerteeinheit 105 ist derart ausgebildet, bezogen auf eine Masse 210 asymmetrisch zu arbeiten, wenn das analoge Prüfsignal 101 bezogen auf ein Massepotential einer Masse 210 bereitgestellt wird, während die Auswerteeinheit 105 derart ausgebildet ist, ohne einen Bezug auf die Masse 210 symmetrisch zu arbeiten, wenn das analoge Prüfsignal 101 nicht auf eine Masse bzw, eine Systemmasse bezogen ist.

Figur 3 zeigt ein Diagramm, welches eine Sensorempfindlichkeit E als Funktion einer Frequenz f darstellt. Eine ideale Sensorkennlinie 303 weist einen nahezu horizontalen Verlauf auf und lässt einen unteren Störfrequenzbereich 304 ebenso wie einen oberen Störfrequenzbereich 305 in gleicher Weise wie einen Nutzfrequenzbereich 301 passieren.

Die in Figur 2 dargestellte erfindungsgemäße Schaltungsanordnung führt zu einer Hochpasssensorkennlinie 302, welche sich dadurch auszeichnet, dass niedrige Störfrequenzen in einem unteren Störfrequenzbereich ausgeblendet werden, was insbesondere bei einem Einsatzbeispiel der Sensoreinheit 101 als Klopfsensor in Automobilmotoren einen erheblichen Vorteil bedeutet, da akustische Signale unterhalb typischerweise 1 kHz einem auszuwertenden Messsignal nicht zugeordnet werden. Da die Klopfgeräusche bevorzugt im oberen Frequenzbereich 301 auftreten und Störungen eher im Bereich 304 zu erwarten sind, ist der Verlauf 302 also vorteilhaft.

Der in Figur 3 dargestellte Nutzfrequenzbereich erstreckt sich für Anwendungen als Klopfsensor in Fahrzeugen typischerweise von 1 kHz bis 30 kHz.

Figur 5 zeigt sechs unterschiedliche Fehler- bzw. Störfälle, wovon die ersten fünf (Figur 5(a) - Figur 5(e)) durch das erfindungsgemäße Verfahren überwacht werden sollen. Hierbei handelt es sich im Einzelnen um:
a) eine Unterbrechung des ersten Sensorsignalpfads 201a;
b) einen Masseschluss des ersten Sensorsignalpfads 201a zu dem Massepfad 208;
c) einen Kurzschluss zwischen dem ersten Sensorsignalpfad 201a und dem zweiten Sensorsignalpfad 201b;
d) eine Unterbrechung des zweiten Sensorsignalpfads 201b;
e) einen Masseschluss zwischen dem zweiten Sensorsignalpfad 201b und dem Massepfad 208.

Der in Figur 5(f) (durchgestrichene Teilfigur) auftretende Fall einer Verbindung des ersten Sensorsignalpfads 201a und/oder des zweiten Sensorsignalpfads 201b mit einem Versorgungsspannungspfad 207, d.h. ein Versorgungsspannungsschluss, wird in dem erfindungsgemäßen Verfahren zum Überwachen von Sensoreinheiten nicht berücksichtigt, da dieser Fehlfunktionsfall durch geeignete Maßnahmen (Isolation des Versorgungsspannungspfads 207) ausgeschlossen werden kann.

Das Spannungsteilerwiderstandselement 204 ist, wie unter Bezugnahme auf Figur 2 erläutert, zwischen den Versorgungsspannungspfad 207 und den Spannungsteilerausgangsanschluss 211 geschaltet, so dass das analoge Prüfsignal 101 an dem Spannungsteileranschluss 211 abgegriffen werden kann.

Bezüglich der in Figur 4 dargestellten, herkömmlichen Schaltungsanordnung zur Überwachung einer Sensoreinheit wird auf die Beschreibungseinleitung verwiesen.

### Bezugszeichenliste

In den Figuren bezeichnen gleiche Bezugszeichen gleiche oder funktionsgleiche Komponenten oder Schritte.
- 100: Sensoreinheit
- 101: Analoges Prüfsignal
- 102: Messsignal
- 103: Analog-Digital-Konverter
- 104: Messgröße
- 105: Auswerteeinheit
- 106: Fehlerbestimmungssignal
- 107: Digitales Prüfsignal
- 201a: Erster Sensorsignalpfad
- 201b: Zweiter Sensorsignalpfad
- 202: Sensorelement
- 202a: Erster Sensorelementkontaktierung
- 202b: Zweite Sensorelementkontaktierung
- 203: Ableitwiderstandselement
- 204: Spannungsteilerwiderstandselement
- 205: Entstörkapazität
- 206: Koppelkapazität
- 207: Versorgungsspannungspfad
- 208: Massepfad
- 209: Versorgungsspannung
- 210: Masse
- 211: Spannungsteilerausgangsanschluss
- 301: Nutzfrequenzbereich
- 302: Hochpasssensorkennlinie
- 303: Herkömmliche Sensorkennlinie
- 304: Unterer Störfrequenzbereich
- 305: Oberer Störfrequenzbereich
- 401: Hochohmiges Ableitwiderstandselement
- 402: Prüfsignal

## Patentansprüche

1. Verfahren zum Überwachen einer Sensoreinheit (100), bei dem ein analoges Prüfsignal (101) ausgewertet wird, mit den Schritten:
a) Betreiben der Sensoreinheit (100) in einem vorgebbaren Betriebszustand;
b) Ableiten eines analogen Prüfsignals (101) von der Sensoreinheit (100);
c) Auswerten des analogen Prüfsignals (101) in einer Auswerteeinheit (105), um eine Funktionsfähigkeit der Sensoreinheit (100) in dem vorgegebenen Betriebszustand zu bestimmen;
d) Ausgeben eines Fehlerbestimmungssignals (106) in Abhängigkeit von der Funktionsfähigkeit der Sensoreinheit (100);
e) wobei das analoge. Prüfsignal (101) als ein Gleichspannungssignal, DC, bereitgestellt wird; und
f) ein Messsignal, das von der Sensoreinheit (100) ausgegeben wird, über eine Koppelkapazität (205) aus dem analogen Prüfsignal ausgekoppelt wird.

2. Verfahren nach einem oder beiden der Ansprüche 1,
**dadurch gekennzeichnet,**
**dass** mittels eines Analog-Digital-Konverters (103) eine Konvertierung des analogen Prüfsignals (101) in ein digitales Prüfsignal (107) bereitgestellt wird.

3. Verfahren nach einem oder mehreren der voranstehenden Ansprüche,
**dadurch gekennzeichnet,**
**dass** in einer Auswerteeinheit (105) eine Gleichspannungsauswertung derart durchgeführt wird, dass ein einem Gleichspannungspegel entsprechender digitaler Wert des digitalen Prüfsignals (107) ausgewertet wird.

4. Verfahren nach einem oder mehreren der voranstehenden Ansprüche,
**dadurch gekennzeichnet,**
**dass** in der Auswerteeinheit (105) eine Unterbrechung eines ersten Sensorsignalpfads (201a) erfasst wird.

5. Verfahren nach einem oder mehreren der voranstehenden Ansprüche,
**dadurch gekennzeichnet,**
**dass** in der Auswerteeinheit (105) eine Unterbrechung eines zweiten Sensorsignalpfads (201b) erfasst wird.

6. Verfahren nach einem oder mehreren der voranstehenden Ansprüche,
**dadurch gekennzeichnet,**
**dass** in der Auswerteeinheit (105) eine elektrische Verbindung zwischen dem ersten Sensorsignalpfad (201a) und dem zweiten Sensorsignalpfad (201b) erfasst wird.

7. Verfahren nach einem oder mehreren der voranstehenden Ansprüche,
**dadurch gekennzeichnet,**
**dass** in der Auswerteeinheit (105) eine elektrische Verbindung zwischen dem ersten Sensorsignalpfad (201a) und einem Massepfad (208) erfasst wird.

8. Verfahren nach einem oder mehreren der voranstehenden Ansprüche,
**dadurch gekennzeichnet,**
**dass** in der Auswerteeinheit (105) eine elektrische Verbindung zwischen dem zweiten Sensorsignalpfad (201b) und dem Massepfad (208) erfasst wird.

9. Verfahren nach einem oder mehreren der voranstehenden Ansprüche,
**dadurch gekennzeichnet,**
**dass** ein in der Sensoreinheit (100) parallel zu einem Sensorelement (202) geschaltetes Ableitwiderstandselement (203)
einen Verlauf einer Sensorsempfindlichkeit als Funktion einer Frequenz in der Form einer Hochpasssensorkennlinie (302) bewirkt.

10. Verfahren nach einem oder mehreren der voranstehenden Ansprüche,
**dadurch gekennzeichnet,**
**dass** die durch die Beschaltung mit dem Ableitwiderstandselement (203) gebildete Hochpasssensorkennlinie (302) bewirkt, dass nur ein Nutzfrequenzbereich (301) von 1 kHz bis 30 kHz über die ersten und zweiten Sensorsignalpfade (201a, 201b) übertragen wird.

11. Verfahren nach einem oder mehreren der voranstehenden Ansprüche,
**dadurch gekennzeichnet,**
**dass** ein Spannungsteilerwiderstandselement (204) zusammen mit dem in Reihe geschalteten Ableitwiderstandselement (203) einen Spannungsteiler ausbildet, wobei an einem Spannungsteilerausgangsanschluss (211) das analoge Prüfsignal (101) erhältlich ist.

12. Verfahren nach einem oder mehreren der voranstehenden Ansprüche,
**dadurch gekennzeichnet,**
**dass** ein Massepfad (208) der Sensoreinheit (100) nicht notwendigerweise mit einer Systemmasse übereinstimmt.

13. Verfahren nach einem oder mehreren der voranstehenden Ansprüche,
**dadurch gekennzeichnet,**
**dass** ein Massepfad der Sensoreinheit (100) mit dem zweiten Sensorsignalpfad (201b) übereinstimmt.

14. Verfahren nach einem oder mehreren der voranstehenden Ansprüche,
**dadurch gekennzeichnet,**
**dass** als eine Versorgungsspannung (209) eine positive oder eine negative Spannung bezogen auf ein Massepotential einer Masse (210) anlegbar ist.

15. Verfahren nach einem oder mehreren der voranstehenden Ansprüche,
**dadurch gekennzeichnet,**
**dass** das analoge Prüfsignal (101) asymmetrisch ausgewertet wird, wobei die Sensoreinheit (100) bezogen auf den Massepfad (208) geschaltet wird.

16. Verfahren nach einem oder mehreren der voranstehenden Ansprüche,
**dadurch gekennzeichnet,**
**dass** das in Reihe zu dem Ableitwiderstandselement geschaltete Spannungsteilerwiderstandselement (204) eine Dämpfung der Empfindlichkeit bei niedrigen, nicht im Nutzfrequenzbereich (301) liegenden Frequenzen bewirkt.

17. Verfahren nach einem oder mehreren der voranstehenden Ansprüche,
**dadurch gekennzeichnet,**
**dass** das Prüfsignal (101) symmetrisch ausgewertet wird, wobei ein Spannungsteiler mit mindestens zwei Widerständen bereitgestellt wird.

18. Vorrichtung zur Überwachung einer Sensoreinheit (100) durch Auswertung eines von der Sensoreinheit abgeleiteten analogen Prüfsignals (101) gemäß dem Verfahren nach Anspruch 1 mit:
a) einem in der Sensoreinheit (100) parallel zu einem Sensorelement (202) geschalteten Ableitwiderstandselement (203);
b) ersten und zweiten Sensorsignalpfaden (201a; 201b);
c) einem Spannungsteilerwiderstandelement (204), das zusammen mit dem Ableitwiderstandselement (203) einen Spannungsteiler zur Bereitstellung des analogen Prüfsignals fur eine Gleichspannungsauswertung ausbildet; und
d) einem Spannungsteilerausgangsanschluss (211) zur Ausgabe des analogen Prüfsignals (101).

19. Vorrichtung nach Anspruch 18,
**dadurch gekennzeichnet,**
**dass** das Spannungsteilerwiderstandselement (204) zwischen einen Versorgungsspannungspfad (207) und den Spannungsteilerausgangsanschluss (211) geschaltet ist.

20. Vorrichtung nach einem oder beiden der Ansprüche 18 und 19,
**dadurch gekennzeichnet,**
**dass** ein Analog-Digital-Konverter (103) bereitgestellt ist,
um eine Konvertierung des analogen Prüfsignals (101) in ein digitales Prüfsignal (107) zu bewirken.

21. Vorrichtung nach einem oder mehreren der Ansprüche 18 bis 20,
**dadurch gekennzeichnet,**
**dass** die ersten und zweiten Sensorsignalpfade (201a, 201b) eine Länge von mehreren Metern aufweisen, ohne dass eine Verfälschung des analogen Prüfsignals (101) auftritt.

22. Vorrichtung nach einem oder mehreren der Ansprüche 18 bis 21,
**dadurch gekennzeichnet,**
**dass** das Sensorelement (202) als ein Piezoelement ausgebildet ist.

23. Vorrichtung nach einem oder mehreren der Ansprüche 18 bis 22,
**dadurch gekennzeichnet,**
**dass** das Spannungsteilerwiderstandselement (204) durch eine Stromquelle ersetzbar ist.

24. Vorrichtung nach einem oder mehreren der Ansprüche 18 bis 23,
**dadurch gekennzeichnet,**
**dass** eine Auswerteeinheit (105) bereitgestellt ist, um aus dem digitalen Prüfsignal (107) ein Fehlerbestimmungssignal (106) abzuleiten.

25. Vorrichtung nach einem oder mehreren der Ansprüche 18 bis 24,
**dadurch gekennzeichnet,**
**dass** die Auswerteeinheit (105) derart ausgebildet ist, bezogen auf eine Masse (210) asymmetrisch zu arbeiten.

26. Vorrichtung nach einem oder mehreren der Ansprüche 18 bis 25,
**dadurch gekennzeichnet,**
**dass** die Auswerteeinheit (105) derart ausgebildet ist, ohne Bezug auf die Masse (210) symmetrisch zu arbeiten.

27. Vorrichtung nach einem oder mehreren der Ansprüche 18 bis 26,
**dadurch gekennzeichnet,**
**dass** eine Entstörkapazität (205) bereitgestellt ist, die zwischen den ersten Sensorsignalpfad (201a) und den zweiten Sensorsignalpfad (201b) geschaltet ist.

## Claims

1. Method for monitoring a sensor unit (100), in which an analogue test signal (101) is evaluated and which has the following steps:
a) the sensor unit (100) is operated in an operating state which can be predetermined;
b) an analogue test signal (101) is derived by the sensor unit (100);
c) the analogue test signal (101) is evaluated in an evaluation unit (105) in order to determine the serviceability of the sensor unit (100) in the predetermined operating state;
d) a fault determination signal (106) is output as a function of the serviceability of the sensor unit (100);
e) with the analogue test signal (101) being provided in the form of a DC voltage signal DC; and
f) a measurement signal, which is output by the sensor unit (100), being extracted from the analogue test signal by means of a coupling capacitance (205).

2. Method according to Claim 1,
**characterized in that**
an analogue/digital converter (103) is used to convert the analogue test signal (101) to a digital test signal (107).

3. Method according to one or more of the preceding claims,
**characterized in that**
DC voltage evaluation is carried out in an evaluation unit (105) in such a manner that a digital value (which corresponds to a DC voltage level) of the digital test signal (107) is evaluated.

4. Method according to one or more of the preceding claims,
**characterized in that**
an interruption in a first sensor signal path (201a) is detected in the evaluation unit (105).

5. Method according to one or more of the preceding claims,
**characterized in that**
an interruption in a second sensor signal path (201b) is detected in the evaluation unit (105).

6. Method according to one or more of the preceding claims,
**characterized in that**
an electrical connection between the first sensor signal path (201a) and the second sensor signal path (201b) is detected in the evaluation unit (105).

7. Method according to one or more of the preceding claims,
**characterized in that**
an electrical connection between the first sensor signal path (201a) and an earth path (208) is detected in the evaluation unit (105).

8. Method according to one or more of the preceding claims,
**characterized in that**
an electrical connection between the second sensor signal path (201b) and the earth path (208) is detected in the evaluation unit (105).

9. Method according to one or more of the preceding claims,
**characterized in that**
a bleed resistance element (203), which is connected in parallel with a sensor element (202) in the sensor unit (100), produces a profile of the sensor sensitivity as a function of frequency in the form of a high-pass sensor characteristic (302).

10. Method according to one or more of the preceding claims,
**characterized in that**
the high-pass sensor characteristic (302) formed as a result of the connection to the bleed resistance element (203) causes only a wanted frequency range (301) of 1 kHz to 30 kHz to be transmitted over the first and second sensor signal paths (201a, 201b).

11. Method according to one or more of the preceding claims,
**characterized in that**
a voltage divider resistance element (204), together with the series-connected bleed resistance element (203), forms a voltage divider, with it being possible to obtain the analogue test signal (101) at a voltage divider output connection (211).

12. Method according to one or more of the preceding claims,
**characterized in that**
an earth path (208) in the sensor unit (100) does not necessarily correspond to a system earth.

13. Method according to one or more of the preceding claims,
**characterized in that**
an earth path in the sensor unit (100) corresponds to the second sensor signal path (201b).

14. Method according to one or more of the preceding claims,
**characterized in that**
a positive or negative voltage - with respect to an earth potential of an earth (210) - can be applied as a supply voltage (209).

15. Method according to one or more of the preceding claims,
**characterized in that**
the analogue test signal (101) is evaluated asymmetrically, with the sensor unit (100) being connected relative to the earth path (208).

16. Method according to one or more of the preceding claims,
**characterized in that**
the voltage divider resistance element (204), which is connected in series with the bleed resistance element, attenuates the sensitivity at low frequencies which are not in the wanted frequency range (301).

17. Method according to one or more of the preceding claims,
**characterized in that**
the test signal (101) is evaluated symmetrically, with a voltage divider which has at least two resistors being provided.

18. Apparatus for monitoring a sensor unit (100) by evaluating an analogue test signal (101), which is derived by the sensor unit, in accordance with the method according to Claim 1, having:
a) a bleed resistance element (203) which is connected in parallel with a sensor element (202) in the sensor unit (100);
b) first and second sensor signal paths (201a, 201b);
c) a voltage divider resistance element (204) which, together with the bleed resistance element (203), forms a voltage divider for providing the analogue test signal for DC voltage evaluation; and
d) a voltage divider output connection (211) for outputting the analogue test signal (101).

19. Apparatus according to Claim 18,
**characterized in that**
the voltage divider resistance element (204) is connected between a supply voltage path (207) and the voltage divider output connection (211).

20. Apparatus according to one or both of Claims 18 and 19,
**characterized in that**
an analogue/digital converter (103) is provided in order to convert the analogue test signal (101) to a digital test signal (107).

21. Apparatus according to one or more of Claims 18 to 20,
**characterized in that**
the first and second sensor signal paths (201a, 201b) have a length of several metres without the analogue test signal (101) being corrupted.

22. Apparatus according to one or more of Claims 18 to 21,
**characterized in that**
the sensor element (202) is in the form of a piezoelement.

23. Apparatus according to one or more of Claims 18 to 22,
**characterized in that**
the voltage divider resistance element (204) may be replaced by a current source.

24. Apparatus according to one or more of Claims 18 to 23,
**characterized in that**
an evaluation unit (105) is provided in order to derive a fault determination signal (106) from the digital test signal (107).

25. Apparatus according to one or more of Claims 18 to 24,
**characterized in that**
the evaluation unit (105) is designed so as to operate asymmetrically with respect to an earth (210).

26. Apparatus according to one or more of Claims 18 to 25,
**characterized in that**
the evaluation unit (105) is designed so as to operate symmetrically without regard to earth (210).

27. Apparatus according to one or more of Claims 18 to 26,
**characterized in that**
an interference suppression capacitance (205), which is connected between the first sensor signal path (201a) and the second sensor signal path (201b), is provided.

## Revendications

1. Procédé pour contrôler une unité de détection (100), selon lequel un signal analogique de contrôle (101) est analysé au cours des étapes suivantes :
a) l'unité de détection (100) est amenée à un état de fonctionnement qui peut être prédéfini,
b) un signal analogique de contrôle (101) est donné par l'unité de détection (100),
c) le signal analogique de contrôle (101) est évalué dans une unité d'évaluation (105) pour déterminer le caractère opérationnel de l'unité de détection (100) dans l'état de fonctionnement qui peut être prédéfini,
d) délivrance d'un signal de détermination d'erreur (106) en fonction du caractère opérationnel de l'unité de détection (100),
e) le signal analogique de contrôle (101) est mis à disposition sous la forme d'un signal à tension continue, DC, et
f) un signal de mesure délivré par l'unité de détection (100) est déclenché à partir du signal de contrôle analogique par l'intermédiaire d'une capacité de couplage (205).

2. Procédé selon la revendication 1,
**caractérisé en ce que**
un convertisseur analogique-numérique (103) transforme le signal analogique de contrôle (101) en un signal numérique de contrôle (107).

3. Procédé selon une ou plusieurs des revendications précédentes,
**caractérisé en ce que**
dans une unité d'évaluation (105) est évaluée une tension continue, de manière à établir, en correspondance avec cette tension, une valeur du signal numérique de contrôle (107).

4. Procédé selon une ou plusieurs des revendications précédentes,
**caractérisé en ce que**
dans l'unité d'évaluation (105) est saisie une interruption d'une première voie (201a) du signal de détection.

5. Procédé selon une ou plusieurs des revendications précédentes,
**caractérisé en ce que**
dans l'unité d'évaluation (105) est saisie une interruption d'une seconde voie (201b) du signal de détection.

6. Procédé selon une ou plusieurs des revendications précédentes,
**caractérisé en ce que**
dans l'unité d'évaluation (105) est saisie une liaison électrique entre la première voie (201a) et la seconde voie (201b) du signal de détection.

7. Procédé selon une ou plusieurs des revendications précédentes,
**caractérisé en ce que**
dans l'unité d'évaluation (105) est saisie une liaison électrique entre la première voie (201a) du signal de détection et une voie de masse (208).

8. Procédé selon une ou plusieurs des revendications précédentes,
**caractérisé en ce que**
dans l'unité d'évaluation (105) est saisie une liaison électrique entre la seconde voie (201b) du signal de détection et une voie de masse (208).

9. Procédé selon une ou plusieurs des revendications précédentes,
**caractérisé en ce qu'**
un élément résistant de dérivation (203) monté dans l'unité de détection (100) en parallèle avec un élément de détection (202) crée une représentation de la sensibilité du détecteur en tant que fonction d'une fréquence, sous la forme d'une caractéristique de détecteur passe-haut (302).

10. Procédé selon une ou plusieurs des revendications précédentes,
**caractérisé en ce que**
la caractéristique de détecteur passe-haut (302) formée par la connexion avec l'élément de résistance de dérivation (203) fait que seulement une zone de fréquence utile (301) allant de 1 kHz à 30 kHz est transmise par la première et la seconde voie de signal de détection (201a, 201b).

11. Procédé selon une ou plusieurs des revendications précédentes,
**caractérisé en ce que**
un élément résistant de diviseur de tension (204) constitue, en série avec l'élément résistant de dérivation (203), un diviseur de tension permettant d'obtenir le signal de contrôle analogique (101)sur un raccord de sortie (211) de ce diviseur.

12. Procédé selon une ou plusieurs des revendications précédentes,
**caractérisé en ce que**
une voie de masse (208) de l'unité de détection (100) ne correspond pas nécessairement à une masse du système.

13. Procédé selon une ou plusieurs des revendications précédentes,
**caractérisé en ce qu'**
une voie de masse de l'unité de détection (100) correspond à la seconde voie de signal de détection (201b).

14. Procédé selon une ou plusieurs des revendications précédentes,
**caractérisé en ce qu'**
une tension positive ou négative par rapport au potentiel d'une masse (210) peut être appliquée, comme tension d'alimentation (209).

15. Procédé selon une ou plusieurs des revendications précédentes,
**caractérisé en ce que**
l'unité de détection (101) étant connectée par rapport à la voie de masse (208), le signal analogique de contrôle (101) est évalué asymétriquement.

16. Procédé selon une ou plusieurs des revendications précédentes,
**caractérisé en ce qu'**
un élément résistant de diviseur de tension (204) monté en série avec l'élément résistant de dérivation produit un amortissement de la sensibilité pour des fréquences basses qui ne se trouvent pas dans la zone de fréquence utile (301).

17. Procédé selon une ou plusieurs des revendications précédentes,
**caractérisé en ce que**
le signal analogique de contrôle (101) est évalué symétriquement, en disposant d'un diviseur de tension comportant au moins deux résistances.

18. Dispositif pour surveiller une unité de détection (100) en évaluant un signal de contrôle analogique (101) dérivé de l'unité de détection selon le procédé de la revendication 1, et qui comporte :
a) un élément résistant de dérivation (203) montée dans l'unité de détection (100) en parallèle avec un élément de détection (202),
b) une première et une seconde voie du signal de détection (201a, 201b),
c) un élément résistant de diviseur de tension (204) qui constitue avec l'élément résistant de dérivation (203) un diviseur de tension pour disposer de signal analogique de contrôle destiné à une évaluation de la tension continue, et
d) un raccord de sortie (211) du diviseur de tension pour délivrer le signal analogique de contrôle (101),

19. Dispositif selon la revendication 18,
**caractérisé en ce que**
l'élément résistant de diviseur de tension (204) est monté entre une ligne de tension d'alimentation (207) et le raccord de sortie (211) du diviseur de tension.

20. Dispositif selon au moins une des deux revendications 18 et 19,
**caractérisé en ce qu'**
on dispose d'un convertisseur analogique-numérique (103) pour transformer le signal analogique de contrôle (101) en un signal numérique de contrôle (107).

21. Dispositif selon une ou plusieurs des revendications 18 à 20,
**caractérisé en ce que**
la première et la seconde voie du signal de détection (201a, 201b) présentent chacune une longueur de plusieurs mètres sans que cela fausse le signal analogique de contrôle (101).

22. Dispositif selon une ou plusieurs des revendications 18 à 21,
**caractérisé en ce que**
l'élément de détection (202) est un élément piézo-électrique.

23. Dispositif selon une ou plusieurs des revendications 18 à 22,
**caractérisé en ce que**
l'élément résistant du diviseur de tension (204) peut être remplacé par une source de courant.

24. Dispositif selon une ou plusieurs des revendications 18 à 23,
**caractérisé en ce qu'**
il dispose d'une unité d'évaluation (105) pour dériver du signal digital de contrôle (107) un signal de détermination d'erreur (106).

25. Dispositif selon une ou plusieurs des revendications 18 à 24,
**caractérisé en ce que**
l'unité d'évaluation (105) est conçue de manière à fonctionner asymétriquement par rapport à une masse (210).

26. Dispositif selon une ou plusieurs des revendications 18 à 25,
**caractérisé en ce que**
l'unité d'évaluation (105) est conçue de manière à fonctionner symétriquement par rapport à la masse (210).

27. Dispositif selon une ou plusieurs des revendications 18 à 26,
**caractérisé en ce qu'**
il dispose d'une capacité d'antiparasitage (205) montée entre la première voie (201a) et la seconde voie (201b) de signal de détection.
